# EUROPEAN PATENT APPLICATION

(11) **EP 3 067 400 A1**
(43) Date of publication of application: **14.09.2016**
(21) Application number: 14860131.3
(22) Date of filing: 20.10.2014
(51) Int. Cl.: C09J 123/08, C09J 7/02, C09J 11/06

(54) **ADHESIVE COMPOSITION**

(30) Priority: 05.11.2013 JP 2013229642
(71) Applicant: Mitsubishi Plastics, Inc., Tokyo 100-8252 (JP)
(72) Inventor: INENAGA, Makoto, Nagahama-shi Shiga 526-8660 (JP); FUKUDA, Shinya, Nagahama-shi Shiga 526-8660 (JP)
(74) Representative: Hoffmann Eitle
(86) International application number: PCT/JP2014/077820
(87) International publication number: WO 2015/068558

(57) **Abstract**

Provided is an adhesive composition which has cutting processability when it is fitted to the shape of an adherend part before pasting and processed, long-term storage stability at a normal temperature before pasting of the cut shape after processing, low temperature melting properties of not imparting damage to the adherend part when being pasted, and uneven step absorbability after pasting. Hence, an adhesive composition which contains a crosslinking agent and a photopolymerization initiator at from 1 to 50 parts by weight and from 0.3 to 3 parts by weight based on 100 parts by weight of an ethylene-α-olefin-based copolymer, respectively, and has a crystal melting peak by DSC of from 30 to 80°C is proposed.

## Description

### TECHNICAL FIELD

The present invention relates to an adhesive composition exhibiting excellent cutting processability, storage stability, uneven step absorbability, wet heat resistance, light resistance, low dielectric properties, and resistance to metal corrosion. In particular, the invention relates to a transparent sealing material which can be suitably used as a constituent part of a mobile terminal (PDA) such as a smart phone, an image display device such as a tablet, a personal computer, a game machine, a television (TV), a car navigation system, a touch panel, or a pen tablet, a solar cell module such as an organic thin film or dye-sensitization, or an organic EL element, and an optical device laminated body using the same.

### BACKGROUND ART

In recent years, in order to improve the visibility of the image display device, it has been carried out to suppress the reflection of incident light or light emitted from the display image at the air layer interface by filling the gap, between various kinds of image display panels such as a liquid crystal display (LCD), a plasma display (PDP), an organic electroluminescence display (OELD), a micro-electro-mechanical shutter display (MEMSD), and an electronic paper and a protective panel or a touch panel part which is disposed on the front surface side (viewing side) thereof, with a pressure sensitive adhesive sheet, a liquid adhesive, or the like.

As the method to fill such a gap between the constituent parts for image display device with a pressure sensitive adhesive, a method is known in which a liquid adhesive resin composition containing an ultraviolet curable resin is filled in the gap and is cured by being irradiated with ultraviolet light (Patent Document 1).

However, in such a method, not only the work when filling the liquid is cumbersome and the productivity is inferior but also there is a problem that it is difficult to obtain a stable quality as the adhesive at the location where ultraviolet light hardly reaches such as the portion to be concealed by the print concealing layer is not cured and thus flows at a normal temperature or overflows to contaminate the part.

In addition, a method to fill the gap between the constituent parts for image display device with a pressure sensitive adhesive sheet is also known. For example, a transparent pressure sensitive adhesive sheet which has one or more of first pressure sensitive adhesive layers and one or more of second pressure sensitive adhesive layers which exhibit different viscoelastic behaviors from each other, respectively, and has a configuration in which these layers are laminated and integrated, and in which the value of the dynamic shear storage elastic modulus G' measured at the temperature variance and a frequency of 1 Hz is within a specific range is disclosed in Patent Document 2 as a transparent pressure sensitive adhesive sheet that can be suitably used to paste a transparent panel such as a protective panel or a touch panel to the image display panel.

A transparent double-sided pressure sensitive adhesive sheet which has an intermediate resin layer and a pressure sensitive adhesive layer as front and back surface layers and in which both of the layers are a layer containing one or more kinds of a (meth)acrylic acid ester-based (co)polymer as a base resin, the storage shear elastic modulus of the intermediate resin layer at a frequency of 1 Hz is higher than that of the pressure sensitive adhesive layer in a temperature range of from 0 to 100°C, and the indentation hardness (Asker C2 hardness) of the entire sheet is from 10 to 80 is disclosed in Patent Document 3.

In addition, a sheet using a hot-melt type adhesive composition which contains urethane (meth)acrylate having a weight average molecular weight of from 20,000 to 100,000 as a major component and in which the loss tangent of the uncured composition at 25°C is less than 1 and the temperature, at which the loss tangent of the uncured composition becomes 1 or more, is 80°C or lower is disclosed in Patent Document 4.

A sealing material for solar cell in which an ethylene-α-olefin copolymer is thermally cured using an organic peroxide is disclosed in Patent Documents 5 and 6.

### CITATION LIST

### PATENT DOCUMENT

Patent Document 1: WO 2010/027041 A
Patent Document 2: WO 2010/044229 A
Patent Document 3: WO 2011/129200 A
Patent Document 4: WO 2010/038366 A
Patent Document 5: JP 2011-012246 A
Patent Document 6: JP 2012-009754 A

### SUMMARY OF THE INVENTION

### PROBLEM TO BE SOLVED BY THE INVENTION

In the field of the image display device, especially such as mobile phones or mobile terminals, the diversification of design is advanced in addition to thinning and high definition, and a new problem has arisen along with that. For example, it has been general hitherto to print a frame-shaped black concealing portion on the peripheral portion of the front surface protective panel, but along with the diversification of design, it has begun to adopt a design in which this frame-shaped concealing portion is formed in a color other than black and the area of the viewing screen is widened while thinning the printing width to have a narrow frame and maintaining the external dimensions of the casing size. In the case of forming the concealing portion in a color other than black, there is a tendency that the height of the concealing portion, namely, the height of the printing portion becomes thicker and thinner compared to black since concealing properties of a color other than black are poor. Hence, the adhesive sheet for pasting a constituent part equipped with such a printing portion is required to exhibit printing step absorbability which can absorb a great printing step and fill every corner.

In addition, a greater stress is applied to the place in contact with the printing portion of the image display device compared to other places as the height of the printing portion becomes thicker and thinner, there is a possibility that distortion is caused so as to adversely affect the optical characteristics, and thus it is also required to suppress such distortion.

For this reason, the filling part such as an adhesive sheet is required to exhibit higher stress relaxation properties (flowability), but there is a possibility that antifoaming reliability of the laminated parts to which an adhesive sheet is pasted decreases as well as the long-term storage stability of the adhesive sheet at a normal temperature before pasting or the workability at the time of handling is impaired when only the flowability is enhanced.

However, in Patent Document 2, the uneven step absorbability is insufficient since the transparent pressure sensitive adhesive sheet has been crosslinked in advance and thus does not exhibit flowability. In addition, in Patent Document 3, the front and back surface layers of the transparent double-sided pressure sensitive adhesive sheet is soft to exhibit uneven step absorbability to a certain extent but the intermediate resin layer is hard to exhibit insufficient uneven step absorbability.

In Patent Document 4, the adhesive composition is an amorphous adhesive composition that is solid at a normal temperature, and thus the cut shape after it is cut so as to fit to the adherend part shape before being pasted is possibly stable for a short period of time at a normal temperature. However, the adhesive composition before pasting exhibits insufficient long-term storage stability at a normal temperature and thus is practically required to be stored cold, for example, at 5°C or lower.

In addition, in Patent Documents 5 and 6 described above, a curing temperature of 100°C or higher is required in order to thermally cure the sealing material using an organic peroxide, and thus there is a possibility that the image display device or the optical device constituent part of an adherend part is damaged.

Furthermore, the filling part used in the integration of parts such as a pressure sensitive adhesive sheet is required to be further thinned as not only the parts are lightened and thinned but also the gap between the parts is narrowed along with lightening and thinning of the image display device. Accordingly, the pressure sensitive adhesive sheet is required to concurrently exhibit printing step absorbability and reliability after pasting in a further higher technical level than ever. However, it is the reality that there is none which meets all of these aspects in the prior art.

### MEANS FOR SOLVING PROBLEM

In order to solve such problems, the invention proposes an adhesive composition which contains a crosslinking agent (B) and a photopolymerization initiator (C) at from 1 to 50 parts by weight and from 0.3 to 3 parts by weight based on 100 parts by weight of an ethylene-α-olefin-based copolymer (A), respectively, and has a crystal melting peak by DSC of from 30 to 80°C.

In the adhesive composition proposed by the invention, it is preferable that a storage elastic modulus G' of the adhesive composition in an uncured state at a temperature of 100°C and a frequency of 1 Hz is 0.1 kPa or more and less than 20 kPa and a loss tangent tan δ is 1 or more.

In the adhesive composition proposed by the invention, it is preferable that a storage elastic modulus G' of the adhesive composition in an uncured state at a temperature of 20°C and a frequency of 1 Hz is 300 kPa or more and less than 5000 kPa.

In the adhesive composition proposed by the invention, it is preferable that a storage elastic modulus G' of the adhesive composition in a cured state at a temperature of 100°C and a frequency of 1 Hz is 20 kPa or more and less than 1000 kPa and a loss tangent tan δ is less than 1.

In the adhesive composition proposed by the invention, it is preferable that a total light transmittance is 89% or more and haze is 3.0% or less.

### EFFECT OF THE INVENTION

The adhesive composition proposed by the invention does not impart damage to the optical device constituent part of an adherend part at the time of adhesion, and can absorb the step between uneven adherend parts without causing a gap and paste them such that the non-adhesive surface side of the adherend part is smoothly finished when an uneven adherend part is pasted to the surface as a transparent sealing material. In addition, the adhesive composition can achieve all of the excellent effects such as cutting processability when the adhesive composition is fitted to the adherend part shape before being pasted and processed, long-term storage stability at a normal temperature before the adhesive composition is pasted to the cut shape after processing, low temperature melting properties that the adhesive composition does not damage the adherend part when being pasted, uneven step absorbability after pasting, photocuring properties in order to impart durability, long-term reliability (heat resistance, wet heat resistance, and resistance to metal corrosion), and electrical characteristics.

### BRIEF DESCRIPTION OF DRAWINGS

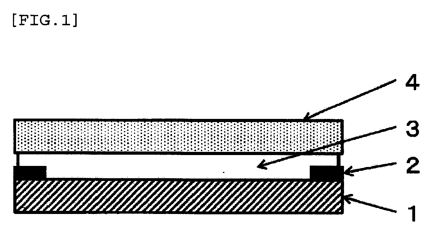

Fig. 1 is a cross-sectional diagram of a sample for pasting property test for evaluating pasting properties and a sample for heat resistance test for evaluating heat resistance in Examples.

### MODE(S) FOR CARRYING OUT THE INVENTION

Hereinafter, embodiments of the adhesive composition of the invention will be described in detail. However, it is not necessarily limited thereto.

### [Adhesive composition]

The adhesive composition according to an example of embodiments of the invention (referred to as the "present adhesive composition") is one that contains an ethylene-α-olefin-based copolymer (A), a crosslinking agent (B), and a photopolymerization initiator (C).

The present adhesive composition melts and flows by being heated so that it can absorb the step between uneven adherend parts without causing a gap at the time of pasting by heating and paste them such that the non-adhesive surface side of the adherend part is smoothly finished. Thereafter, the present adhesive composition is cured by being irradiated with an active energy ray together with the adherend part so that the storage elastic modulus G' is improved, the durability required for practical use can be obtained, and the problem such as reflow, misalignment between adherend parts, peeling, and bubbling in a long-term reliability test can be solved.

### [Ethylene-α-olefin-based copolymer (A)]

The ethylene-α-olefin-based copolymer (A) in the present adhesive composition (A) is a copolymer of ethylene and α-olefin.

The ethylene-α-olefin-based copolymer (A) has a crystal structure derived from an ethylene chain, the crystal melting peak thereof based on a differential scanning calorimeter (DSC) is a normal temperature (25°) or higher, and it is possible to retain a high storage elastic modulus G' that the crystal structure is maintained and the copolymer does not flow at a normal temperature.

Hence, it is possible to obtain one that exhibits excellent cutting processability when being processed and excellent long-term storage stability at a normal temperature before pasting of the cut shape after processing.

The kind of α-olefin to be copolymerized with ethylene is not particularly limited. Usually, an α-olefin having from 3 to 20 carbon atoms is suitably used as the α-olefin, and examples thereof may include propylene, 1-butene, 1-pentene, 1-hexene, 1-heptene, 1-octene, 1-nonene, 1-decene, and 3-methyl-butene-1,4-methyl-pentene-1. Among them, a copolymer having 1-butene, 1-hexene, or 1-octene as the α-olefin as a copolymer component is preferable from the viewpoint of ease of industrial availability and economic efficiency.

Incidentally, the α-olefin to be copolymerized with ethylene may be used singly or two or more kinds thereof may be used in combination at an arbitrary ratio.

In addition, the content of the α-olefin to be copolymerized with ethylene is not particularly limited. The content of the α-olefin is preferably 2 mol% or more and 40 mol% or less based on the entire monomers used in the copolymerization, among them, it is more preferably 3 mol% or more or 30 mol% or less, and among them, it is even more preferably 5 mol% or more or 25 mol% or less.

It is preferable that the content of the α-olefin to be copolymerized with ethylene is within the range described above since the crystallinity is decreased by the copolymer component and the transparency (for example, total light transmittance and haze) is improved. In addition, it is preferable that the content of the α-olefin to be copolymerized with ethylene is within the range described above since the occurrence of blocking, or the like is suppressed in the case of preparing a raw material pellet. Incidentally, the kind and content of the α-olefin to be copolymerized with ethylene can be analyzed by a well-known method, for example, using a device for nuclear magnetic resonance (NMR) measurement or another device for instrumental analysis.

The ethylene-α-olefin copolymer (A) may contain a monomer unit based on a monomer other than the α-olefin.

Examples of the monomer unit may include a cyclic olefin, a vinyl aromatic compound (styrene or the like), and a polyene compound.

The content of the monomer unit is preferably 20 mol% or less and more preferably 15 mol% or less when the total monomer units in the ethylene-α-olefin copolymer are set to 100 mol%.

In addition, the steric structure, branch, branching degree distribution, molecular weight distribution, or copolymerization form (random, block, or the like) of the ethylene-α-olefin copolymer are not particularly limited. For example, a copolymer having a long chain branch generally have favorable mechanical properties and also advantages that the melt tension increases when molding a film, calender moldability is improved, and the like. Incidentally, the copolymer having a long chain branch can be obtained by a method to add a small amount of a multifunctional monomer to the system at the time of polymerization.

The upper limit of the crystal melting peak temperature of the ethylene-α-olefin copolymer (A) is not particularly limited. The upper limit of the crystal melting peak temperature of the ethylene-α-olefin copolymer (A) is preferably 100°C or lower, more preferably 80°C or lower, and even more preferably 65°C or lower in consideration of the transparency or low temperature flexibility, pasting suitability, or the like. In addition, the lower limit of the crystal melting peak temperature is preferably 20°C or higher, more preferably 30°C or higher, and even more preferably 40°C or higher in consideration of prevention of blocking of raw material pellets, shape-retaining performance of the sealing film at room temperature, or the like. In addition, the crystal melting peak temperature may be plural.

The quantity of crystal melting heat for the ethylene-α-olefin copolymer (A) is not particularly limited. The quantity of crystal melting heat for the ethylene-α-olefin copolymer (A) is preferably from 0 to 100 J/g, among them, it is more preferably 5 J/g or more or 80 J/g or less, and among them, it is even more preferably 10 J/g or more or 65 J/g or less. It is preferable that the quantity of crystal melting heat is within the range described above since the flexibility or transparency (total light transmittance and haze) of the adhesive composition is secured. Incidentally, the crystal melting peak temperature and the quantity of crystal melting heat can be measured at a heating rate of 10°C/min using a differential scanning calorimeter (DSC) in accordance with JIS K7121.

The MFR (JIS K7210: a temperature of 190°C and a load of 21.18 N) of the ethylene-α-olefin copolymer (A) is not particularly limited. The MFR of the ethylene-α-olefin copolymer (A) is preferably 5 g/10 min or more and 60 g/10 min or less, among them, it is even more preferably 8 g/10 min or more or 50 g/10 min or less, and among them, it is even more preferably 10 g/10 min or more or 45 g/10 min or less.

As the ethylene-α-olefin-based copolymer (A), an ethylene-α-olefin copolymer having a density of from 0.850 to 0.900 g/cm³ is preferable, and among them, an ethylene-α-olefin copolymer having a density of 0.860 or more or 0.885 g/cm³ or less is more preferable in order to impart excellent transparency, pasting suitability, low temperature characteristics, or the like.

As the ethylene-α-olefin-based copolymer (A), among the ethylene-α-olefin copolymers described above, an ethylene-α-olefin random copolymer is even more preferable from the viewpoint of low crystallinity and excellent light transmittance and flexibility. Only one kind of these may be used singly or two or more kinds thereof may be used as a mixture.

The method for producing the ethylene-α-olefin copolymer (A) is not particularly limited, and a known polymerization method using a known catalyst for ethylene polymerization can be employed. Examples of known polymerization method may include a slurry polymerization method, a solution polymerization method, and a vapor phase polymerization method which use a multi-site catalyst represented by a Ziegler-Natta type catalyst or a single-site catalyst represented by a metallocene-based catalyst or a post-metallocene-based catalyst, and a bulk polymerization method which uses a radical initiator. In the invention, it is preferable to produce the ethylene-α-olefin copolymer (A) using a polymerization method which uses a single-site catalyst and can polymerize raw materials which contains a small amount of low molecular weight component and has narrow molecular weight distribution from the viewpoint of ease of palletization after polymerization or prevention of blocking of raw material pellets.

The ethylene-α-olefin-based copolymer (A) may be mixed with an ethylene-α-olefin-based copolymer having a different composition or molecular weight or a copolymer having a different crystal melting peak and a different melt viscosity, such as an another functional group-modified ethylene-α-olefin-based copolymer.

The ethylene-α-olefin copolymer (A) may be a modified ethylene-α-olefin-based copolymer. The kind of the modified ethylene-α-olefin copolymer is not particularly limited. Examples thereof may include a silane-modified ethylene-α-olefin and an acid-modified ethylene-α-olefin.

The method for producing the modified ethylene-α-olefin-based copolymer is not particularly limited. For example, a silane-modified ethylene-α-olefin can be obtained by melting and mixing an ethylene-α-olefin-based copolymer, a silane coupling agent to be described later, and a radical generator at a high temperature and subjecting the mixture to graft polymerization. In addition, an acid-modified ethylene-α-olefin can be obtained by melting and mixing an ethylene-α-olefin, anhydrous maleic acid, and a radical generator at a high temperature and subjecting the mixture to graft polymerization.

### [Crosslinking agent (B)]

The crosslinking agent (B) can improve the storage elastic modulus G' of the adhesive composition after curing (also referred to as the "present pressure sensitive adhesive cured composition") as the crosslinking agent (B) undergoes the crosslinking reaction with the ethylene-α-olefin-based copolymer (A) or forms a network therebetween when the present adhesive composition is irradiated with an active energy ray together with the adherend part so that the composition does not reflow after being pasted by heating, the crosslinking agent (B) can impart the durability required for practical use to the present pressure sensitive adhesive cured composition, and the crosslinking agent (B) can solve the problem such as reflow, misalignment between adherend parts, peeling, and bubbling in a long-term reliability test.

The crosslinking agent (B) is not particularly limited. As the crosslinking agent (B), it is preferable to select and use a linear aliphatic, cyclic aliphatic, or aromatic crosslinking agent among the monofunctional and bifunctional or higher polyfunctional crosslinking agents such as a vinyl esters and (meth)acrylic acid esters which can undergo a radical crosslinking reaction, and among them, it is more preferable to use an aliphatic or cyclic aliphatic crosslinking agent having 6 or more carbon atoms in consideration of compatibility with the ethylene-α-olefin-based copolymer (A), the transparency of the adhesive composition, and the stability after processing.

By using such a highly hydrophobic crosslinking agent, the crosslinking agent (B) is easily mixed with the ethylene-α-olefin-based copolymer (A) that is an aliphatic resin and highly hydrophobic and it is possible to suppress a change in quality of the adhesive composition such as bleed-out or phase separation and a decrease in transparency during long-term storage.

The content of the crosslinking agent (B) is preferably from 1 to 50 parts by weight, more preferably from 1 to 20 parts by weight, and even more preferably from 1 to 10 parts by weight based on 100 parts by weight of the ethylene-α-olefin-based copolymer (A). By containing the crosslinking agent (B) in the range described above, not only the adhesive composition before curing has sufficient shape stability but also bubbling after curing can be sufficiently suppressed.

Specific examples of the crosslinking agent (B) may include isobornyl (meth)acrylate, lauryl (meth)acrylate, stearyl (meth)acrylate, 1,6-hexanediol di(meth)acrylate, 1,8-octanediol di(meth)acrylate, 1,9-nonanediol di(meth)acrylate, 1,10-decanediol di(meth)acrylate, 1,12-dodecanediol di(meth)acrylate, and tricyclodecanedimethanol di(meth)acrylate. These crosslinking agents may be used singly or a plurality thereof may be used.

In the case of using plural kinds of crosslinking agents (B), it is preferable to use a monofunctional (meth)acrylate and a polyfunctional (meth)acrylate in combination. This makes it possible to suppress the shrinkage due to an active energy ray at the time of curing or enhance the compatibility with the ethylene-α-olefin-based copolymer (A).

### [Photopolymerization initiator (C)]

The photopolymerization initiator (C) plays a role of a radical generator for causing a radical crosslinking reaction of the crosslinking agent (B) when the present adhesive composition is irradiated with an active energy ray together with the adherend part after being pasted to the adherend part by heating.

It is possible to cure the present adhesive composition at a low temperature in a short time by containing the photopolymerization initiator (C), and thus it is possible to sufficiently avoid damaging the optical device constituent part of an adherend part when a transparent sealing material composed of the present adhesive composition is laminated with an optical device constituent part.

The photopolymerization initiator (C) are classified greatly into two by the radical generation mechanism, and it is roughly classified into a cleavage type photopolymerization initiator that can generate a radical as the photopolymerization initiator itself decomposes through the cleavage of the single bond thereof and a hydrogen abstraction type photopolymerization initiator in which the photoexcited initiator and a hydrogen donor in the system can form an excited complex and can transfer hydrogen of the hydrogen donor.

The cleavage type photopolymerization initiator is decomposed to be converted into another compound when generating a radical by being irradiated with light, and thus it does not have the function as a reaction initiator after it is once excited. For this reason, the cleavage type photopolymerization initiator is preferable since it does not remain as an active species in the adhesive composition after the completion of the crosslinking reaction and it is not concerned that unexpected light deterioration of the adhesive composition is brought about.

Meanwhile, the hydrogen abstraction type photopolymerization initiator is useful since it does not generate a decomposed product as the cleavage type photopolymerization initiator at the time of the radical generation reaction by irradiation with an active energy ray such as ultraviolet light, and thus it is hardly converted into a volatile component after the completion of the reaction, and damage of the adherend part can be decreased.

Examples of the cleavage type photopolymerization initiator may include 2,2-dimethoxy-1,2-diphenylethane-1-one, 1-hydroxycyclohexyl phenyl ketone, 2-hydroxy-2-methyl-1-phenyl-propane-1-one, 1-(4-(2-hydroxyethoxy)phenyl)-2-hydroxy-2-methyl-1-propan-1-one, 2-hydroxy-1-[4-{4-(2-hydroxy-2-methyl-propionyl)benzyl}phenyl]-2-methyl-propan-1-one, oligo(2-hydroxy-2-methyl-1-(4-(1-methylvinyl)phenyl)propanone), methyl phenylglyoxylate, 2-benzyl-2-dimethylamino-1-(4-morpholinophenyl)butane-1-one, 2-methyl-1-[4-(methylthio)phenyl]-2-morpholino-1-one, 2-(dimethylamino)-2-[(4-methylphenyl)methyl]-1-[4-(4-morpholinyl)phenyl]-1-butanone, bis(2,4,6-trimethylbenzoyl)-phenylphosphine oxide, 2,4,6-trimethylbenzoyldiphenylphosphine oxide, or any derivative thereof.

Examples of the hydrogen abstraction type photopolymerization initiator may include benzophenone, 4-methyl-benzophenone, 2,4,6-trimethylbenzophenone, 4-phenylbenzophenone, 3,3'-dimethyl-4-methoxybenzophenone, methyl 2-benzoylbenzoate, methyl benzoylformate, bis(2-phenyl-2-oxoacetic acid)oxy-bis-ethylene, 4-(1,3-acryloyl-1,4,7,10,13-penta-oxo-tridecyl)benzophenone, thioxanthone, 2-chlorothioxanthone, 3-methylthioxanthone, 2,4-dimethylthioxanthone, 2-methylanthraquinone, 2-ethylanthraquinone, 2-tert-butyl-anthraquinone, 2-aminoanthraquinone, or any derivative thereof.

However, the photopolymerization initiator (C) is not limited to the materials mentioned above. As the photopolymerization initiator (C), any one kind of the cleavage type photopolymerization initiator and the hydrogen abstraction type photopolymerization initiator may be used or both of them may be used in combination.

The content of the photopolymerization initiator (C) is from 0.3 to 3 parts by weight and preferably from 0.3 to 2 parts by weight based on 100 parts by weight of the ethylene-α-olefin-based copolymer (A), and it is even more preferably 0.5 part by weight or more or 1.5 parts by weight or less among them. It is possible to exhibit proper reactivity with respect to the active energy ray by containing the photopolymerization initiator (C) in the range described above.

### [Additive]

The present adhesive composition may contain various additives if necessary.

Examples of the additive may include a silane coupling agent, an antioxidant, a weathering stabilizer, a processing aid, a nucleating agent, an antistatic agent, an ultraviolet absorber, a flame retardant, and a discoloration preventing agent. These additives may be used singly or in combination of two or more kinds thereof. A silane coupling agent, an antioxidant, a weathering stabilizer, and a processing aid will be described below among these.

### (Silane coupling agent)

The silane coupling agent is useful in order to improve the adhesive properties of the present adhesive composition with respect to a protective material (glass, a plastic front sheet, a back sheet, or the like), a solar cell module, or the like when a transparent sealing material composed of the present adhesive composition is used, and examples thereof may include a compound having an unsaturated group such as a vinyl group, acryloxy group, or a methacryloxy group, and a hydrolyzable functional group such as an alkoxy group as well as an amino group, an epoxy group, or the like. Specific examples of the silane coupling agent may include N-β-aminoethyl)-γ-aminopropyltrimethoxysilane, N-β-aminoethyl)-γ-aminopropylmethyldimethoxysilane, γ-aminopropyltriethoxysilane, γ-glycidoxypropyltrimethoxysilane, and γ-methacryloxypropyltrimethoxysilane.

Among them, in the present adhesive composition, γ-glycidoxypropyltrimethoxysilane or γ-methacryloxypropyltrimethoxysilane can be preferably used from the viewpoint of favorable adhesive properties, decreased discoloration such as yellowing, and the like. One kind of the silane coupling agents may be used singly or two or more kinds thereof may be used in combination.

The amount of the silane coupling agent added is preferably from about 0.1 to 5 parts by mass and more preferably from 0.2 to 3 parts by mass based on 100 parts by mass of the present adhesive composition. In addition, a coupling agent such as an organic titanate compound can also be effectively utilized in the same manner as the silane coupling agent.

### (Antioxidant)

The antioxidant is not particularly limited, and various commercially available products can be applied. Examples of the antioxidant may include various types of antioxidants such as a phenol-based antioxidant including a monophenol-based antioxidant, a bisphenol-based antioxidant, and a polymer-type phenol-based antioxidant, a sulfur-based antioxidant, and a phosphite-based antioxidant.

Examples of the monophenol-based antioxidant may include 2,6-di-tert-butyl-p-cresol, butylated hydroxyanisole, 2,6-di-tert-butyl-4-ethylphenol, and octadecyl-3-(3,5-di-tert-butyl-4-hydroxyphenyl)propionate.

Examples of the bisphenol-based antioxidant may include 2,2'-methylene-bis-(4-methyl-6-tert-butylphenol), 2,2'-methylene-bis-(4-ethyl-6-tert-butylphenol), 4,4'-thiobis-(3-methyl-6-tert-butylphenol), 4,4'-butylidene-bis-(3-methyl-6-tert-butylphenol), and 3,9-bis[{1,1-dimethyl-2-{β-(3-tert-butyl-4-hydroxy-5-methylphenyl)propionyloxy}ethyl}2,4,9,10-tetraoxaspiro]5,5-undecane.

Examples of the polymer-type phenol-based antioxidant may include 1,1,3-tris-(2-methyl-4-hydroxy-5-tert-butylphenyl)butane, 1,3,5-trimethyl-2,4,6-tris(3,5-di-tert- butyl-4-hydroxybenzyl)benzene, tetrakis-{methylene-3-(3',5'-di-tert-butyl-4'-hydroxyphenyl)propionate}methane, bis{(3,3'-bis-4'-hydroxy-3'-tert-butylphenyl)butyric acid} glycol ester, 1,3,5-tris(3',5'-di-tert-butyl-4'-hydroxybenzyl)-s-triazine-2,4,6-(1H,3H,5H)trione, and tocopherol (vitamin E).

Examples of the sulfur-based antioxidant may include dilauryl thiodipropionate, dimyristyl thiodipropionate, and distearyl thiopropionate.

Examples of the phosphite-based antioxidant may include triphenyl phosphite, diphenyl isodecyl phosphite, phenyl diisodecyl phosphite, 4,4'-butylidene-bis(3-methyl-6-tert-butylphenyl-di-tridecyl) phosphite, cyclic neopentanetetrayl-bis(octadecyl phosphite), tris(mono-and/or di-nonylphenyl) phosphite, tris(2,4-di-tert-butylphenyl) phosphite, diisodecyl pentaerythritol phosphite, 9,10-dihydro-9-oxa-10-phosphaphenanthrene-10-oxide, 10-(3,5-di-tert-butyl-4-hydroxybenzyl)-9,10-dihydro-9-oxa-10-phosphaphenanthrene-10-oxide, 10-decyloxy-9,10-dihydro-9-oxa-10-phosphaphenanthrene, cyclic neopentanetetrayl-bis(2,4-di-tert-butylphenyl)phosphite, cyclic neopentanetetrayl-bis(2,6-di-tert-butylphenyl)phosphite, and 2,2-methylene-bis(4,6-tert-butylphenyl)octylphosphite.

In the present adhesive composition, a phenol-based and phosphite-based antioxidants are preferably used from the viewpoint of the effect of antioxidant, thermal stability, economic efficiency, and the like, and it is even more preferable to use both of them in combination since it is possible to enhance the effect as an antioxidant as compared to the amount added.

The amount of the antioxidant added is not particularly limited, but it is preferably 1 part by mass or more and 0.1 part by mass or less based on 100 parts by mass of the present adhesive composition, and it is even more preferably 0.2 part by mass or more or 0.5 part by mass or less among them.

### (Weathering stabilizer)

As the weathering stabilizer to impart weather resistance, a hindered amine-based light stabilizer is suitably used. Examples of the hindered amine-based light stabilizer may include succinic acid dimethyl-1-(2-hydroxyethyl)-4-hydroxy-2,2,6,6-tetramethylpiperidine polycondensate, poly[16-(1,1,3,3-tetra-methylbutyl)amino-1,3,5-triazine-2,4-diyl}{(2,2,6,6-tetra-methyl-4-piperidyl)imino}hexamethylene{2,2,6,6-tetramethyl-4-piperidyl}imino}], N,N'-bis(3-aminopropyl)ethylenediamine-2,4-bis[N-butyl-N-(1,2,2,6,6-pentamethyl-4-piperidyl)amino]-6-chloro-1,3,5-triazine condensate, bis(2,2,6,6-tetramethyl-4-piperidyl) separate, and 2-(3,5-di-tert-4-hydroxybenzyl)-2-n-butylmalonic acid bis(1,2,2,6,6-pentamethyl-4-piperidyl).

The amount of the weathering stabilizer added is not particularly limited, but it is preferably 1 part by mass or more and 0.01 parts by mass or less and more preferably 0.05 by mass or more and 0.5 parts by mass or less based on 100 parts by mass of the present adhesive composition.

### (Processing aid)

The processing aid can be used for adjustment of the fine stickiness of the present adhesive composition or adjustment of flow at the time of heating and melting. For example, it is possible to appropriately select and add paraffin oil, inorganic or organic nanoparticles to the extent to which the transparency is not alienated.

### [Other resins]

The present adhesive composition can contain a resin other than (A) above for the purpose of further improving physical properties (flexibility, heat resistance, transparency, adhesive properties, and the like), molding processability, economic efficiency, or the like. Examples thereof may include a polyolefin-based resin having a functional group, an ionomer resin, a tackifying resin, and various kinds of elastomers.

### (Polyolefin-based resin having functional group)

The kind of the polyolefin-based resin having a functional group is not particularly limited. For example, it is preferably at least one kind of resin selected from the group consisting of an ethylene-vinyl acetate copolymer (EVA), an ethylene-vinyl alcohol copolymer (EVOH), an ethylene-methyl methacrylate copolymer (E-MMA), an ethylene-ethyl acrylate copolymer (E-EAA), and an ethylene-glycidyl methacrylate copolymer (E-GMA).

Specific examples of the polyolefin-based resin having a functional group which can be used in the present adhesive composition may include "NOVATECH-EVA" of a trade name manufactured by Japan Polyethylene Corporation, "EVAFLEX" of a trade name manufactured by DU PONT-MITSUI POLYCHEMICALS CO., LTD., "NUC" series of a trade name manufactured by NUC Corporation as EVA, "SOARNOL" of a trade name manufactured by The Nippon synthetic chemical Co., Ltd. and "EVAL" of a trade name manufactured by KURARAY CO., LTD. as EVOH, "ACRYFT" of a trade name manufactured by Sumitomo Chemical Co., Ltd. as E-MMA, "REXPEARL EEA" of a trade name manufactured by Japan Polyethylene Corporation as E-EAA, and "BONDFAST" of a trade name manufactured by Sumitomo Chemical Co., Ltd. as E-GMA.

### (Ionomer resin)

Examples of the kind of the ionomer resin may include an ionically crosslinkable ethylene-methacrylic acid copolymer or an ionically crosslinkable ethylene-acrylic acid copolymer. The method for producing the ionomer resin is not particularly limited, but for example, it can be obtained by neutralizing at least a portion of the unsaturated carboxylic acid component of a copolymer composed of ethylene, an unsaturated carboxylic acid, and another unsaturated compound as an arbitrary component with at least either one of a metal ion or an organic amine.

In addition, the ionomer resin can be obtained, for example, by saponifying at least a portion of the unsaturated carboxylic acid ester component of a copolymer composed of ethylene, an unsaturated carboxylic acid ester, and another unsaturated compound as an arbitrary component. Specific examples thereof may include "HIMILAN" of a trade name manufactured by DU PONT-MITSUI POLYCHEMICALS CO., LTD.

### (Tackifying resin)

Examples of the tackifying resin may include a petroleum resin, a terpene resin, a coumarone-indene resin, a rosin-based resin, or any hydrogenated derivative thereof.

Examples of the petroleum resin may include an alicyclic petroleum resin from cyclopentadiene or a dimer thereof or an aromatic petroleum resin from a C9 component.

Examples of the terpene resin may include a terpene resin from β-pinene or a terpene-phenol resin.

Examples of the coumarone-indene resin may include a coumarone-indene copolymer and a coumarone-indene-styrene copolymer.

In addition, examples of the rosin-based resin may include a rosin resin such as gum rosin and wood rosin, and an esterified rosin resin that is modified with glycerol, pentaerythritol, or the like.

The content of the tackifying resin is not particularly limited. For example, it is preferably 20 parts by mass or less and more preferably 10 parts by mass or less based on 100 parts by mass of the resin composition which constitutes the transparent sealing material.

### (Various kinds of elastomers)

Various kinds of elastomers are not particularly limited. Examples thereof may include a styrene-based elastomer, a polyester-based elastomer, and a polyamide-based elastomer. Among them, a styrene-based elastomer is preferable from the viewpoint of transparency or hydrolysis resistance.

Examples of the styrene-based elastomer may include SBR (styrene butadiene rubber), SBS (styrene-butylene-styrene block copolymer), SIS (styrene-isobutylene-styrene block copolymer), SEBS (styrene-ethylene-butylene-styrene block copolymer), SEBC (styrene-ethylene-butylene-ethylene block copolymer), and HSBR (hydrogenated styrene-butadiene rubber). The content of styrene is not particularly limited, but it is preferably 20 mol% or less based on the total monomer components which constitute the elastomer from the viewpoint of weather resistance.

### [Multilayer configuration]

The layer configuration of the transparent sealing material formed from the present adhesive composition or the present pressure sensitive adhesive cured composition is not limited as long as the transparent sealing material has at least one or more layers of a transparent sealing layer (layer I), and it may be a single-layer configuration or a multilayer configuration. It is possible to simplify the film-forming process of a transparent sealing layer by adopting the single-layer configuration consists of a single composition.

In addition, it is possible to achieve the various kinds of characteristics required for the transparent sealing layer in a good balance by adopting the multilayer configuration having another layer (layer II) which has a different composition detail and a different composition ratio.

In the transparent sealing material formed from the present adhesive composition or the present pressure sensitive adhesive cured composition, the layer II may have a multilayer configuration formed by laminating different materials. Examples thereof may include a multilayer configuration formed by laminating a transparent inorganic oxide film such as SiO₂ or Al₂O₃ or a barrier film or a retardation film for display as an intermediate layer or a multilayer configuration having a surface layer equipped with a known pressure sensitive adhesive or adhesive.

Examples of the multilayer configuration of the transparent sealing material formed from the present adhesive composition or the present pressure sensitive adhesive cured composition may include a two-layer by two-kind configuration such as layer I/layer II and a three-layer by two-kind configuration such as layer I/layer II/layer I. Furthermore, the number of layers may be increased to four layers, five layers, six layers, and seven layers if necessary. Among them, layer I/layer II/layer I is more preferable from the viewpoint of the uneven step absorbability when pasting.

With regard to the total thickness ratio of layer I to layer II in such a multilayer configuration, the value of layer I/layer II is preferably from 0.05 to 20, among them, it is more preferably 0.1 or more or 15 or less, and among them, it is even more preferably 0.5 or more or 12 or less. It is possible to sufficiently secure the uneven step absorbability when pasting as the value of layer I/layer II is in the range described above.

Incidentally, the transparent sealing material formed from the present adhesive composition or the present pressure sensitive adhesive cured composition may be formed into a transparent sealing film laminated body formed by laminating a protective film on one surface or both surfaces of the transparent sealing material regardless of the configuration of the transparent sealing material.

### [Physical properties of present adhesive composition]

The crystal melting peak of the present adhesive composition in the temperature raising process measured by a differential scanning calorimeter (DSC) in accordance with JIS K7121 is preferably from 30 to 80°C in an uncured state and a cured state, among them, it is preferably 35°C or higher or 70°C or lower, and among them, it is more preferably is 40°C or higher or 65°C or lower. Incidentally, it has been confirmed that a difference in crystal melting peak is not acknowledged even when the crystal melting peaks of the present adhesive composition before curing and after curing are compared to each other.

The crystal melting peak of the present adhesive composition is derived from the crystal structure of the ethylene-α-olefin-based copolymer (A). As the crystal melting peak of the present adhesive composition is in the temperature range described above, the composition does not flow since the crystal structure is maintained in a storage environment at a normal temperature and a high storage elastic modulus G' can be retained. Furthermore, it is possible to absorb the uneven step since it is possible to allow the composition to flow while melting the crystal in a temperature range in which an image display device or an optical device constituent part of an adherend part is not damaged.

On the other hand, when the crystal melting peak is lower than 30°C, the shape stability of the sheet (rolled article or cut processed article) before pasting at the time of long-term storage at room temperature or transport is not sufficiently obtained, and thus the composition is required to be stored cold. Meanwhile, when the crystal melting peak is a temperature higher than 80°C, the composition is required to be hot-melt pasted at a higher temperature, and thus there is a possibility that an image display device or an optical device constituent part of an adherend part is damaged.

In order to adjust the crystal melting peak of the present adhesive composition or the present pressure sensitive adhesive cured composition into the range described above, it is preferable to adjust the kind or content of the α-olefin in the ethylene-α-olefin copolymer (A), the primary structure (randomness) thereof, and the like. However, it is not limited to that method.

The storage elastic modulus G' of the present adhesive composition in an uncured state at a temperature of 20°C and a frequency of 1 Hz is preferably 300 kPa or more and less than 5000 kPa, among them, it is even more preferably 500 kPa or more or 4000 kPa or less, and among them, it is even more preferably 700 kPa or more or 3500 Pa or less.

The transparent sealing material can secure sufficient stability during long-term storage at a normal temperature when using a transparent sealing material composed of the present adhesive composition as the storage elastic modulus G' of the composition in an uncured state at a temperature of 20°C and a frequency of 1 Hz is 300 kPa or more. Meanwhile, the transparent sealing material exhibits fine stickiness as the storage elastic modulus G' of the composition in an uncured state at a temperature of 20°C and a frequency of 1 Hz is less than 5000 kPa, and thus handling properties such as positioning at the time of pasting can be sufficiently exhibited.

Hence, when the storage elastic modulus G' of the composition in an uncured state at a temperature of 20°C and a frequency of 1 Hz is 300 kPa or more and less than 5000 kPa, it is possible to exhibit long-term storage properties at a normal temperature and fine stickiness and handling such positioning by temporary fixing at the time of pasting can be easy when using a transparent sealing material composed of an adhesive composition.

In order to adjust the storage elastic modulus G' of the present adhesive composition at a temperature of 20°C and a frequency of 1 Hz into the range described above, it is preferable to adjust the density or crystallinity of the ethylene-α-olefin copolymer (A) or to change the kind or content of the crosslinking agent (B), the photopolymerization initiator (C), or other resins and additives. However, it is not limited to that method.

The storage elastic modulus G' of the present adhesive composition in an uncured state at a temperature of 100°C and a frequency of 1 Hz is preferably 0.1 kPa or more and less than 20 kPa, among them, it is even more preferably 0.3 kPa or more or 15 kPa or less, and among them, it is even more preferably 0.5 kPa or more or 10 kPa or less.

It is possible to sufficiently suppress overflow from the adherend part due to flow of the present adhesive composition at the time of heating and pasting when the storage elastic modulus G' of the composition in an uncured state at a temperature of 100°C and a frequency of 1 Hz is 0.1 kPa or more. Meanwhile, sufficient uneven step absorbability is exhibited and the non-adhesive surface side of the adherend part can be smoothly finished when the storage elastic modulus G' of the composition in an uncured state is less than 20 kPa.

Hence, as the storage elastic modulus G' of the composition in an uncured state at a temperature of 100°C and a frequency of 1 Hz is 0.1 kPa or more and less than 20 kPa, the adherend part is not damaged, the step between uneven adherend parts is sufficiently absorbed without causing a gap at the time of heating and pasting, and it is possible to paste them such that the non-adhesive surface side of the adherend part is smoothly finished.

In order to adjust the storage elastic modulus G' of the present adhesive composition at a temperature of 100°C and a frequency of 1 Hz into the range described above, it is preferable to adjust the molecular weight of the ethylene-α-olefin copolymer (A) or to change the kind or content of the crosslinking agent (B), the photopolymerization initiator (C), or other resins and additives. However, it is not limited to that method.

The loss tangent tan δ of the present adhesive composition in an uncured state at a temperature of 100°C and a frequency of 1 Hz is preferably 1 or more, more preferably 2 or more, and even more preferably 2.5 or more. The upper limit value of the loss tangent tan δ is not particularly limited, but it is preferably 100 or less.

As the loss tangent tan δ of the present adhesive composition in an uncured state at a temperature of 100°C and a frequency of 1 Hz is 1 or more, it is possible to allow the composition to sufficiently flow at the time of heating and pasting, sufficient uneven step absorbability is exhibited without causing a gap at the time of heating and pasting, and it is possible to paste them such that the non-adhesive surface side of the adherend part is smoothly finished.

In order to adjust the loss tangent tan δ of the present adhesive composition at a temperature of 100°C and a frequency of 1 Hz into the range described above, it is preferable to adjust the molecular weight of the ethylene-α-olefin copolymer (A) or to change the kind or content of the crosslinking agent (B), the photopolymerization initiator (C), or other resins and additives. However, it is not limited to that method.

The storage elastic modulus G' of the present adhesive composition in a cured state at a temperature of 100°C and a frequency of 1 Hz is preferably 20 kPa or more and less than 1000 kPa, among them, it is even more preferably 500 kPa or less, and among them, it is even more preferably 30 kPa or more or 300 kPa or less.

Sufficient cohesive force is obtained when the storage elastic modulus G' of the composition in a cured state at a temperature of 100°C and a frequency of 1 Hz is 20 kPa or more. Hence, it is possible to sufficiently suppress the occurrence of misalignment between adherend parts, peeling, and bubbling due to reflow of the composition during the heating test. Meanwhile, it is possible to secure sufficient stress relaxation or adhesive force as an adhesive composition when the storage elastic modulus G' of the composition in a cured state at a temperature of 100°C and a frequency of 1 Hz is less than 1000 kPa.

Hence, as the storage elastic modulus G' of the composition in a cured state at a temperature of 100°C and a frequency of 1 Hz is 20 kPa or more and less than 1000 kPa, the durability required for practical use can be obtained, and the problem such as reflow, misalignment between adherend parts, peeling, and bubbling in a long-term reliability test can be solved.

In order to adjust the storage elastic modulus G' of the present adhesive composition at a temperature of 100°C and a frequency of 1 Hz into the range described above, it is preferable to adjust the molecular weight of the ethylene-α-olefin copolymer (A), to change the kind or content of the crosslinking agent (B), the photopolymerization initiator (C), or other resins and additives, or to increase the quantity of the active energy ray irradiating at the time of curing. However, it is not limited to that method.

The loss tangent tan δ of the present adhesive composition in a cured state at a temperature of 100°C and a frequency of 1 Hz is preferably less than 1, more preferably 0.9 or less, and even more preferably 0.8 or less. The lower limit of the loss tangent tan δ is not particularly limited, but it is preferably 0.01 or more. As the loss tangent tan δ of the composition in a cured state at a temperature of 100°C and a frequency of 1 Hz is less than 1, the present adhesive composition is sufficiently cured by crosslinking, and it is possible to sufficiently obtain the durability required for practical use.

In order to adjust the loss tangent tan δ of the present adhesive composition at a temperature of 100°C and a frequency of 1 Hz into the range described above, it is preferable to adjust the molecular weight of the ethylene-α-olefin copolymer (A), to change the kind or content of the crosslinking agent (B), the photopolymerization initiator (C), or other resins and additives, or to increase the quantity of the active energy ray irradiating at the time of curing. However, it is not limited to that method.

With regard to the present adhesive composition, the total light transmittance measured in accordance with JIS K7361-1 is preferably 89% or more, more preferably 90% or more, and even more preferably 91% or more.

The haze measured in accordance with JIS K7136 is preferably 3.0% or less, more preferably 1.5% or less, and even more preferably 0.7% or less.

As the total light transmittance and the haze are in the range defined above, the present adhesive composition can exhibit sufficient transparency and is suitable when used as a constituent part of a personal digital assistant (PDA) such as a smart phone, an image display device such as a tablet, a personal computer, a game machine, a television (TV), a car navigation system, a touch panel, or a pen tablet, a solar cell module such as an organic thin film or dye-sensitization, or an organic EL element.

In order to adjust the total light transmittance and haze of the present adhesive composition into the range described above, it is preferable to adjust the density or crystallinity of the ethylene-α-olefin copolymer (A) or to change the kind or content of the crosslinking agent (B), the photopolymerization initiator (C), or other resins and additives. However, it is not limited to that method.

### [Transparent sealing material]

The present adhesive composition can be molded into a film to prepare a transparent sealing material, and the transparent sealing material is bonded to an adherend to form a transparent sealing layer. In addition, the present adhesive composition can also be molded into a lump to prepare a transparent sealing material, and also the present adhesive composition in a fluid state can be filled as a transparent sealing material to form a transparent sealing layer. Among them, a method in which the transparent sealing material formed by molding the present adhesive composition into a film is pasted to an optical device constituent part is more preferable since excellent workability is obtained in the case of using the present adhesive composition for configuration of an optical device.

### [Method for producing transparent sealing material]

As the method for producing a transparent sealing material from the present adhesive composition, it is possible to employ a known method, for example, an extrusion casting method, a calendering method, or an inflation method which has melting and mixing equipment such as a single-screw extruder, a multi-screw extruder, the Banbury mixer, or a kneader and uses a T-die. Among them, the extrusion casting method is preferable from the viewpoint of handling properties, productivity, or the like.

The molding temperature in the extrusion casting method using a T-die is appropriately adjusted depending on the flow characteristics, film-forming properties, or the like of the adhesive composition to be used, but it is preferably from 80 to 230°C and more preferably from 90 to 160°C.

The thickness of the transparent sealing material is not particularly limited. It is preferably 0.01 mm or more, more preferably 0.03 mm or more, and even more preferably 0.05 mm or more. Meanwhile, the upper limit thereof is preferably 1 mm or less, more preferably 0.7 mm or less, and even more preferably 0.5 mm or less.

Various kinds of additives such as the silane coupling agent, the antioxidant, and the weathering stabilizer may be supplied to the hopper after being dryblended in advance together with the resin, all of the materials may be melted and mixed and prepared into a pellet in advance and then supplied, or only the additives may be concentrated in the resin to prepare a master batch in advance and then supplied.

In addition, it is preferable to laminate a protective film on one surface or both surfaces of the transparent sealing material from the viewpoint of preventing blocking or foreign matter adhesion. Alternatively, the transparent sealing material may be subjected to embossing processing or various kinds of unevenness (a cone shape, a pyramid shape, a hemispherical shape, or the like) processing if necessary. In addition, the surface of the transparent sealing material may be subjected to various kinds of surface treatments such as a corona treatment, a plasma treatment, and a primer treatment for the purpose of improving the adhesive properties to various kinds of adherend parts.

### [Laminated body for optical device configuration]

The transparent sealing material can be formed into a laminated body for optical device configuration by laminating an optical device constituent part on at least one surface thereof, and an optical device can be configured using the laminated body for optical device configuration.

For example, the transparent sealing material and an optical device constituent part are pasted by heating at 80°C or lower to form a laminated body for optical device configuration, and the transparent sealing material is then cured by irradiating the transparent sealing material with an active energy ray from the optical device constituent part side, whereby a laminated body for optical device configuration can be formed.

Examples of the active energy ray to irradiate may include ionizing radiation such as α rays, β rays, γ rays, neutron rays, and electron beams, ultraviolet light, and visible light, and among them, ultraviolet light is preferable from the point of suppressing the damage to the optical device constituent part or of the reaction control. In addition, the irradiating energy, irradiating time, and irradiating method of the active energy ray are not particularly limited, and the transparent sealing material may be cured by activating the photopolymerization initiator (C) to cause crosslinking.

Examples of the optical device constituent part may include any one kind or a combination of two or more kinds selected from the group consisting of a touch panel, an image display panel, a front surface protective panel, a retardation film, and a polarizing film, and the laminated body for optical device configuration can be used as a laminated body for image display device configuration to configure an image display device.

In addition, examples of the optical device constituent part may include any one kind or a combination of two or more kinds selected from the group consisting of a solar cell, a back surface protective panel, and a front surface protective panel, and the laminated body for optical device configuration can be used as a constituent part of the solar cell module.

In addition, examples of the optical device constituent part may include any one kind or a combination of two or more kinds selected from the group consisting of a front surface protective substrate, an organic EL element, and a back surface protective substrate, and the laminated body for optical device configuration can be used as a constituent part of the organic EL element.

### [Description of terms]

In the present specification, in a case in which it is expressed as "X to Y" (X and Y are an arbitrary number, respectively), it also encompasses the meaning "preferably greater than X" or "preferably less than Y" as well as the meaning "X or more and Y or less" unless otherwise stated.

In addition, in a case in which it is expressed as "X or more" (X is an arbitrary number) or "Y or less" (Y is an arbitrary number), it also encompasses the meaning of intending "preferably greater than X" or "preferably less than Y".

### EXAMPLES

Hereinafter, the invention will be described in more detail with reference to Examples and Comparative Examples. However, the invention is not limited thereto.

### [Example 1]

An adhesive composition 1 was prepared by mixing 20 g of 1,9-nonanediol diacrylate (Biscoat V# 260 manufactured by OSAKA ORGANIC CHEMICAL INDUSTRY LTD.) as the crosslinking agent (B) and 15 g of a photopolymerization initiator (ESACURE TZT manufactured by Lanberti S.p.A.) composed of a mixture of 2,4,6-trimethylbenzophenone with 4-methylbenzophenone as the photopolymerization initiator (C) with 1 kg of an ethylene-butene random copolymer (TAFMER A-35070S manufactured by Mitsui Chemicals, Inc., Density: 870 kg/m³, crystal melting peak: 55°C, content of α-olefin: 14 mol%, quantity of crystal melting heat: 53 J/g, and MFR (190°C, 21.18 N): 35 g/10 min) as the ethylene-α-olefin-based copolymer (A).

The adhesive composition 1 was shaped into a sheet on a release-treated polyethylene terephthalate film (DIAFOIL MRA100 manufactured by Mitsubishi Plastics, Inc., thickness: 100 µm) as a protective film so as to have a thickness of 150 µm, thereby obtaining a transparent sealing film laminated body consisting of two layers. Furthermore, a release-treated polyethylene terephthalate film (DIAFOIL MRF75 manufactured by Mitsubishi Plastics, Inc., thickness: 75 µm) as a protective film was covered on the transparent sealing film, thereby preparing a transparent sealing film laminated body consisting of three layers in which a protective film was laminated on both surfaces of a transparent sealing film. The physical properties of this transparent sealing film are presented in Table 1.

### [Example 2]

A adhesive composition 2 was prepared by mixing 30 g of isobornyl acrylate (light acrylate IBXA manufactured by KYOEISHA CHEMICAL Co., LTD.,) and 10 g of 1,9-nonanediol diacrylate (Biscoat V# 260 manufactured by OSAKA ORGANIC CHEMICAL INDUSTRY LTD.) as the crosslinking agent (B) and 15 g of a photopolymerization initiator (ESACURE TZT manufactured by Lanberti S.p.A.) composed of a mixture of 2,4,6-trimethylbenzophenone with 4-methylbenzophenone as the photopolymerization initiator (C) with 1 kg of an ethylene-butene random copolymer (TAFMER A-35070S manufactured by Mitsui Chemicals, Inc.) and 50 g of a silane modified ethylene-octene random copolymer (LINKLON SL800N manufactured by Mitsubishi Chemical Corporation, density: 868 kg/m³, crystal melting peak: 55°C, content of α-olefin: 11 mol%, quantity of crystal melting heat: 45 J/g, and MFR (190°C, 21.18 N): 1.7 g/10 min) as the ethylene-α-olefin-based copolymer (A).

A transparent sealing film laminated body was prepared in the same manner as in Example 1 using the adhesive composition 2. The physical properties of this transparent sealing film are presented in Table 1.

### [Example 3]

A adhesive composition 3 was prepared by mixing 30 g of 1,9-nonanediol diacrylate (Biscoat V# 260 manufactured by OSAKA ORGANIC CHEMICAL INDUSTRY LTD.) as the crosslinking agent (B) and 15 g of a photopolymerization initiator (ESACURE TZT manufactured by Lanberti S.p.A.) composed of a mixture of 2,4,6-trimethylbenzophenone with 4-methylbenzophenone as the photopolymerization initiator (C) with 1 kg of an ethylene-octene random copolymer (ENGAGE 8130 manufactured by The Dow Chemical Company, density: 864 kg/m³, crystal melting peak: 56°C, content of α-olefin: 12 mol%, quantity of crystal melting heat: 44 J/g, and MFR (190°C, 21.18 N): 13 g/10 min) as the ethylene-α-olefin-based copolymer (A).

A transparent sealing film laminated body was prepared in the same manner as in Example 1 using the adhesive composition 3. The physical properties of this transparent sealing film are presented in Table 1.

### [Example 4]

A adhesive composition 4 was prepared by mixing 20 g of 1,9-nonanediol diacrylate (Biscoat V# 260 manufactured by OSAKA ORGANIC CHEMICAL INDUSTRY LTD.) as the crosslinking agent (B) and 15 g of a photopolymerization initiator (ESACURE TZT manufactured by Lanberti S.p.A.) composed of a mixture of 2,4,6-trimethylbenzophenone with 4-methylbenzophenone as the photopolymerization initiator (C) with 500 g of an ethylene-butene random copolymer (TAFMER A-35070S manufactured by Mitsui Chemicals, Inc.) and 500 g of an ethylene-butene random copolymer (TAFMER A-4050S manufactured by Mitsui Chemicals, Inc., density: 864 kg/m³, crystal melting peak: 39°C, content of α-olefin: 16 mol%, quantity of crystal melting heat: 45 J/g, and MFR (190°C, 21.18 N): 3.6 g/10 min) as the ethylene-α-olefin-based copolymer (A).

A transparent sealing film laminated body was prepared in the same manner as in Example 1 using the adhesive composition 4. The physical properties of this transparent sealing film are presented in Table 1.

### [Example 5]

A adhesive composition 5 was prepared by mixing 20 g of 1,9-nonanediol diacrylate (Biscoat V# 260 manufactured by OSAKA ORGANIC CHEMICAL INDUSTRY LTD.) as the crosslinking agent (B) and 15 g of a photopolymerization initiator (ESACURE TZT manufactured by Lanberti S.p.A.) composed of a mixture of 2,4,6-trimethylbenzophenone with 4-methylbenzophenone as the photopolymerization initiator (C) with 1 kg of an ethylene-octene random copolymer (ENGAGE 8130 manufactured by The Dow Chemical Company) and 50 g of a silane modified ethylene-octene random copolymer (LINKLON SL800N manufactured by Mitsubishi Chemical Corporation) as the ethylene-α-olefin-based copolymer (A).

A transparent sealing film laminated body was prepared in the same manner as in Example 1 using the adhesive composition 5. The physical properties of this transparent sealing film are presented in Table 1.

### [Example 6]

A adhesive composition 6 was prepared by mixing 20 g of 1,9-nonanediol diacrylate (Biscoat V# 260 manufactured by OSAKA ORGANIC CHEMICAL INDUSTRY LTD.) as the crosslinking agent (B) and 15 g of a photopolymerization initiator (ESACURE TZT manufactured by Lanberti S.p.A.) composed of a mixture of 2,4,6-trimethylbenzophenone with 4-methylbenzophenone as the photopolymerization initiator (C) with 1 kg of an ethylene-butene random copolymer (TAFMER A-4050S manufactured by Mitsui Chemicals, Inc.) as the ethylene-α-olefin-based copolymer (A).

A transparent sealing film laminated body was prepared in the same manner as in Example 1 using the adhesive composition 6. The physical properties of this transparent sealing film are presented in Table 1.

### [Example 7]

A adhesive composition 7 was prepared by mixing 20 g of 1,9-nonanediol diacrylate (Biscoat V# 260 manufactured by OSAKA ORGANIC CHEMICAL INDUSTRY LTD.) as the crosslinking agent (B) and 15 g of a photopolymerization initiator (ESACURE TZT manufactured by Lanberti S.p.A.) composed of a mixture of 2,4,6-trimethylbenzophenone with 4-methylbenzophenone as the photopolymerization initiator (C) with 1 kg of a silane modified ethylene-octene random copolymer (LINKLON SL800N manufactured by Mitsubishi Chemical Corporation) as the ethylene-α-olefin-based copolymer (A).

A transparent sealing film laminated body was prepared in the same manner as in Example 1 using the adhesive composition 7. The physical properties of this transparent sealing film are presented in Table 1.

### [Comparative Example 1]

A adhesive composition 8 was prepared by mixing 20 g of 1,9-nonanediol diacrylate (Biscoat V# 260 manufactured by OSAKA ORGANIC CHEMICAL INDUSTRY LTD.) as the crosslinking agent (B) and 15 g of a photopolymerization initiator (ESACURE TZT manufactured by Lanberti S.p.A.) composed of a mixture of 2,4,6-trimethylbenzophenone with 4-methylbenzophenone as the photopolymerization initiator (C) with 1 kg of an ethylene-octene random copolymer (INFUSE 9817 manufactured by The Dow Chemical Company, density: 877 kg/m³, melting point: 120°C, and MFR (190°C, 21.18 N): 15 g/10 min) and 50 g of a silane modified ethylene-octene random copolymer (LINKLON SL800N manufactured by Mitsubishi Chemical Corporation) as the ethylene-α-olefin-based copolymer (A).

A transparent sealing film laminated body was prepared in the same manner as in Example 1 using the adhesive composition 8. The physical properties of this transparent sealing film are presented in Table 2.

### [Comparative Example 2]

A adhesive composition 9 was prepared by mixing 20 g of 1,9-nonanediol diacrylate (Biscoat V# 260 manufactured by OSAKA ORGANIC CHEMICAL INDUSTRY LTD.) as the crosslinking agent (B) and 15 g of t-butylperoxy 2-ethylhexylcarbonate (Luperox TBEC manufactured by ARKEMA Yoshitomi, Ltd., 1 minute half-life temperature: 166°C) of a thermal polymerization initiator as an alternative to the photopolymerization initiator (C) with 1 kg of an ethylene-butene random copolymer (TAFMER A-35070S manufactured by Mitsui Chemicals, Inc.) as the ethylene-α-olefin-based copolymer (A).

A transparent sealing film laminated body was prepared in the same manner as in Example 1 using the adhesive composition 9. The physical properties of this transparent sealing film are presented in Table 2.

### [Comparative Example 3]

An adhesive composition 10 was prepared by mixing 20 g of 1-cyclohexyl phenyl ketone (Irgacure 184 manufactured by BASF) as the photopolymerization initiator (C) with 1 kg of a polyurethane acrylate having a carbonate skeleton (UN5500 manufactured by Negami Chemical Industrial Co., Ltd.) as an alternative to the ethylene-α-olefin-based copolymer (A).

A transparent sealing film laminated body was prepared in the same manner as in Example 1 using the adhesive composition 10. The physical properties of this transparent sealing film are presented in Table 2.

### [Comparative Example 4]

An adhesive composition 11 was prepared by mixing 50 g of isocyanuric acid-ε-caprolactam-modified triacrylate as the crosslinking agent (B) and 20 g of a photopolymerization initiator (ESACURE TZT manufactured by Lanberti S.p.A.) composed of a mixture of 2,4,6-trimethylbenzophenone with 4-methylbenzophenone as the photopolymerization initiator (C) with 1 kg of an acrylic acid ester copolymer (weight average molecular weight: 400,000) obtained through the random copolymerization of 2-ethylhexyl acrylate of 77 parts by mass, vinyl acetate of 19 parts by mass, and acrylic acid of 4 parts by mass as an alternative to the ethylene-α-olefin-based copolymer (A).

The adhesive composition 11 was shaped into a sheet on a release-treated polyethylene terephthalate film (DIAFOIL MRA100 manufactured by Mitsubishi Plastics, Inc., thickness: 100 µm) as a protective film so as to have a thickness of 150 µm, thereby obtaining a transparent sealing film laminated body consisting of two layers. Furthermore, a release-treated polyethylene terephthalate film (DIAFOIL MRF75 manufactured by Mitsubishi Plastics, Inc., thickness: 75 µm) as a protective film was covered on the transparent sealing film. Thereafter, the transparent sealing film was irradiated with ultraviolet light of 1000 mJ from both surfaces together with the polyethylene terephthalate film using a high pressure mercury lamp so as to be crosslinked, thereby preparing a transparent sealing film laminated body consisting of three layers in which a protective film was laminated on both surfaces of a transparent sealing film. The physical properties of this transparent sealing film are presented in Table 2.

### <Evaluation>

### (Crystal melting peak)

Using a differential scanning calorimeter (trade name: Pyris1 DSC manufactured by PerkinElmer Co., Ltd.) in accordance with JIS K7121, the temperature of the adhesive composition or the transparent sealing film was raised from -50°C to 180°C at a heating rate of 10°C/min, held at 180°C for 5 minutes, lowered to -50°C at a cooling rate of 10°C/min, and raised again to 180°C at a heating rate of 10°C/min to measure the thermogram from which the crystal melting peak temperature was determined. Incidentally, in the present Example, the crystal melting peak of the adhesive composition in an uncured state was measured.

### (Storage elastic modulus G')

For the measurement of the storage elastic modulus before curing, those obtained by laminating the transparent sealing films prepared in Examples and Comparative Examples so as to have a thickness of from 1 to 2 mm and punching them into a circle having a diameter of 20 mm were used as the sample for measurement. The measurement was conducted at from -50 to 200°C using a rheometer (MARS manufactured by EKO Instruments) and under the conditions of a pressure sensitive adhesive jig: φ 25 mm parallel plate, a distortion: 0.5%, a frequency: 1 Hz, a temperature: from - 50 to 200°C, and a heating rate of 3°C/min, and the storage elastic modulus G' and the loss tangent tan δ at 20°C and 100°C were determined from the data thus obtained, respectively.

For the measurement of the storage elastic modulus after curing, the transparent sealing films prepared in Examples and Comparative Examples were cured by irradiating the transparent sealing films with ultraviolet light at 365 nm so as to have an integrated light quantity of 2000 mJ/cm² in a state of having the release film laminated thereon using a high pressure mercury lamp. Those obtained by aging the cured transparent sealing films at 23°C and 50% RH for 15 hours or longer and laminating them so as to have a thickness of from 1 to 2 mm were used as the sample for measurement. The measurement was conducted at from -50 to 200°C using a rheometer (MARS manufactured by EKO Instruments) and under the conditions of a pressure sensitive adhesive jig: φ 25 mm parallel plate, a distortion: 0.5%, a frequency: 1 Hz, a temperature: from - 50 to 200°C, and a heating rate of 3°C/min, and the storage elastic modulus G' and the loss tangent tan δ at 20°C and 100°C were determined from the data thus obtained, respectively.

### (Processing suitability)

The transparent sealing film laminated bodies prepared in Examples and Comparative Examples were cut together with the protective film laminated thereon as many as 100 sheets using the 50 mm × 80 mm Thomson blade of the Thomson punching machine, and the shape of the end portion thereof was observed and evaluated on the basis of the following evaluation criteria.
○: collapse of end portion of transparent sealing film laminated body or floating of protective film is observed in less than 10 sheets.
×: collapse of end portion of transparent sealing film laminated body or floating of protective film is observed in 10 sheets or more.

### (Total light transmittance and haze)

The protective film was sequentially peeled off from the transparent sealing film laminated body cut in the section of processing suitability, and soda lime glass (82 mm × 53 mm × 0.5 mm thick) was roll-pasted on both surfaces of the transparent sealing film. The pasted article was subjected to an autoclaving treatment (at 80°C and gauge pressure: 0.2 MPa for 20 minutes) for finish-adhesion, and the resultant was used as the sample for the optical characteristic measurement. For the sample for optical characteristic measurement, the total light transmittance and the haze were measured in accordance with JIS K7361-1 and JIS K7136, respectively, using a haze meter (NDH5000 manufactured by NIPPON DENSHOKU INDUSTRIES Co., LTD.).

### (Storage stability)

The transparent sealing film laminated body cut in the section of processing suitability was laminated so as to be sandwiched between glass plates having a size of 100 mm × 100 mm × 3 mm, a weight of 1 kg was loaded on the glass plate on the top surface, the resultant was aged hours at 40°C for 15 hours, and the state thereof was then observed and evaluated on the basis of the following evaluation criteria.
○: collapse of end portion of transparent sealing film laminated body and overflow of adhesive composition from protective film is not observed.
×: collapse of end portion of transparent sealing film laminated body and overflow of adhesive composition from protective film is observed.

### (Pasting properties)

The protective film on one surface of the transparent sealing film laminated body cut in the section of processing suitability was peeled off, and the transparent sealing film exposed was press-pasted onto the printed surface of soda lime glass (82 mm × 53 mm × 0.5 mm thickness) of which the peripheral portion of 5 mm was printed in a thickness of 80 µm such that the four sides of the transparent sealing film rested on the printing step using a vacuum laminator (model number: PVL0505S manufactured by Nisshinbo Mechatronics Inc.) under the conditions of a temperature: 80°C, a pressing time: 5 minutes, and a pressing pressure: 0.04 MPa. Subsequently, the protective film left on the other surface of the transparent sealing film laminated body was peeled off, and a PMMA plate (trade name: MR200 manufactured by Mitsubishi Rayon Co., Ltd., thickness 0.8 mm) was press-pasted onto the transparent sealing film exposed using a vacuum laminator under the conditions of a temperature: 80°C, a pressing time: 1 minute, and a pressing pressure: 0.04 MPa, the resultant was then subjected to the autoclaving treatment (at 80°C and gauge pressure: 0.2 MPa for 20 minutes) for finish-adhesion, thereby preparing a sample for pasting property test. The sample for pasting property test was visually observed and evaluated on the basis of the following evaluation criteria.
○: those which are smoothly pasted without bubbles.
Δ: those which are smoothly pasted without bubbles although slight unevenness is recognized in the vicinity of printing step when carefully observed under the light.
×: those in which transparent sealing film in the vicinity of printing step floats or unevenness by distortion is recognized.

### (Heat resistance)

The sample for pasting property test that was evaluated to be "○" or "Δ" in the pasting property test was irradiated with ultraviolet light at 365 nm so as to have an integrated light quantity of 2000 mJ/cm² using a high pressure mercury lamp to cure the transparent sealing film, and the resultant was aged at 23°C and 50% RH for 15 hours, and the resultant was used as a sample for heat resistance test. The sample for heat resistance test was heated at 80°C for 3 days, and the presence or absence of bubbling, peeling, and overflow of the transparent sealing film was observed and evaluated on the basis of the following evaluation criteria.
○: those in which any of bubbling, peeling, and overflow of transparent sealing film is not observed.
×: those in which any of bubbling, peeling, and overflow of transparent sealing film is observed.

**[Table 1]**

| | | | Example 1 | Example 2 | Example 3 | Example 4 | Example 5 | Example 6 | Example 7 |
|---|---|---|---|---|---|---|---|---|---|
| Crystal meting peak [°C] | | | 52 | 52 | 54 | 50 | 53 | 42 | 54 |
| Before curing | G' [kPa] | 20° C | 1510 | 1860 | 900 | 1710 | 1100 | 1710 | 1900 |
| | | 100 °C | 2 | 3 | 14 | 14 | 17 | 32 | 60 |
| | tanδ [-] | 100 °C | 7.3 | 5.5 | 2.7 | 2.4 | 2.3 | 2 | 1.3 |
| After curing | G' [kPa] | 100 °C | 42 | 49 | 58 | 60 | 58 | 102 | 210 |
| | tanδ [-] | 100 °C | 0.8 | 0.7 | 0.7 | 0.6 | 0.6 | 0.6 | 0.6 |
| Total light transmittance [%] | | | 91 | 91 | 91 | 91 | 91 | 91 | 91 |
| Haze [%] | | | 0.7 | 0.7 | 0.5 | 0.5 | 0.5 | 0.4 | 0.8 |
| Processing suitability | | | ○ | ○ | ○ | ○ | ○ | ○ | ○ |
| Storage stability | | | ○ | ○ | ○ | ○ | ○ | ○ | ○ |
| Pasting properties | | | ○ | ○ | ○ | ○ | ○ | Δ | Δ |
| Heat resistance | | | ○ | ○ | ○ | ○ | ○ | ○ | ○ |
| Overall evaluation | | | ○ | ○ | ○ | ○ | ○ | Δ | Δ |

**[Table 2]**

| | | | Comparative Example 1 | Comparative Example 2 | Comparative Example 3 | Comparative Example 4 |
|---|---|---|---|---|---|---|
| Crystal meting peak [°C] | | | 120 | 52 | - | - |
| Before curing | G' [kPa] | 20°C | 2500 | 1510 | 200 | 94 |
| | | 100°C | 300 | 2 | 1.6 | 7.3 |
| | tanδ [-] | 100°C | 0.1 | 7.3 | 4.9 | 0.7 |
| After curing | G' [kPa] | 100°C | 500 | 2.9 | 61 | 13 |
| | tanδ [-] | 100°C | 0.6 | 6.6 | 0.6 | 0.4 |
| Total light transmittance [%] | | | < 90 | 91 | 91 | 91 |
| Haze [%] | > 3 | 0.7 | 0.3 | | 0.3 | |
| Processing suitability | ○ | ○ | × | | ○ | |
| Storage stability | ○ | ○ | × | | ○ | |
| Pasting properties | × | ○ | ○ | | × | |
| Heat resistance | - | × | ○ | | - | |
| Overall evaluation | × | × | × | | × | |

The transparent sealing films prepared in Examples 1 to 7 exhibited excellent processing suitability or handling properties and excellent long-term storage stability even though they were not crosslinked as the storage elastic modulus G' thereof in an uncured state at a temperature of 20°C and a frequency of 1 Hz was high. Among them, the transparent sealing films prepared in Examples 1 to 5 were able to exhibit excellent uneven step absorbability as the flowability thereof in an uncured state at 100°C was high.

On the other hand, the transparent sealing film prepared in Comparative Example 1 exhibited inferior pasting properties as it was not able to obtain sufficient flowability at the pasting temperature since the crystal melting peak of the adhesive composition was high.

The transparent sealing film prepared in Comparative Example 2 exhibited inferior heat resistance as it was not able to be sufficiently thermally crosslinked at the pasting temperature since a thermal polymerization initiator was used as an alternative to the photopolymerization initiator (C).

The transparent sealing film prepared in Comparative Example 3 exhibited inferior processing suitability or storage stability as collapse of the end portion of the transparent sealing film laminated body or overflow of the adhesive composition was observed since it did not have a crystal melting peak of the adhesive composition.

In addition, the transparent sealing film prepared in Comparative Example 4 exhibited inferior pasting properties as it was not able to obtain sufficient flowability at the pasting temperature since the crosslinking treatment was conducted in advance at the time of preparing the transparent sealing film.

### EXPLANATIONS OF LETTERS OR NUMERALS

1 Soda lime glass
2 Printing portion
3 Transparent sealing film
4 PMMA plate

## Claims

1. A adhesive composition comprising a crosslinking agent (B) and a photopolymerization initiator (C) at from 1 to 50 parts by weight and from 0.3 to 3 parts by weight based on 100 parts by weight of an ethylene-α-olefin-based copolymer (A), respectively, wherein
a crystal melting peak by DSC is from 30 to 80°C.

2. The adhesive composition according to claim 1, wherein a storage elastic modulus G' of the adhesive composition in an uncured state at a temperature of 100°C and a frequency of 1 Hz is 0.1 kPa or more and less than 20 kPa and a loss tangent tan δ is 1 or more.

3. The adhesive composition according to claim 1 or 2, wherein a storage elastic modulus G' of the adhesive composition in an uncured state at a temperature of 20°C and a frequency of 1 Hz is 300 kPa or more and less than 5000 kPa.

4. The adhesive composition according to any one of claims 1 to 3, wherein a storage elastic modulus G' of the adhesive composition in a cured state at a temperature of 100°C and a frequency of 1 Hz is 20 kPa or more and less than 1000 kPa and a loss tangent tan δ is less than 1.

5. The adhesive composition according to any one of claims 1 to 4, wherein a total light transmittance is 89% or more and haze is 3.0% or less.

6. A transparent sealing material, formed of the adhesive composition according to any one of claims 1 to 5.

7. A transparent sealing film laminated body comprising a configuration having a protective film laminated on both surfaces of the transparent sealing material according to claim 6.

8. A laminated body for optical device configuration comprising a configuration having an optical device constituent part laminated on at least one surface of the transparent sealing material according to claim 6.

9. The laminated body for image display device configuration according to claim 8, wherein the optical device constituent part comprises any one kind or a combination of two or more kinds selected from the group consisting of a touch panel, an image display panel, a front surface protective panel, a retardation film, and a polarizing film.

10. A solar cell module comprising a configuration having an optical device constituent part comprising any one kind or a combination of two or more kinds selected from the group consisting of a solar cell, a back surface protective panel, and a front surface protective panel laminated on at least one surface of the transparent sealing material according to claim 6.

11. An organic EL element comprising a configuration having an optical device constituent part comprising any one kind or a combination of two or more kinds selected from the group consisting of a front surface protective substrate, an organic EL element, and a back surface protective substrate laminated on at least one surface of the transparent sealing material according to claim 6.

12. A method for producing a laminated body for optical device configuration, the method comprising:
heating an optical device constituent part at 80°C or lower to paste on at least one surface of the transparent sealing material according to claim 6, and
irradiating the transparent sealing material with an active energy ray from the optical device constituent part side to cure the transparent sealing material.
